# EUROPEAN PATENT APPLICATION

(11) **EP 2 159 639 A1**
(43) Date of publication of application: **03.03.2010**
(21) Application number: 09168275.7
(22) Date of filing: 20.08.2009
(51) Int. Cl.: G03F 7/20

(54) **Fluid handling structure, lithographic apparatus and device manufacturing method**

(30) Priority: 02.09.2008 US 136380 P
(71) Applicant: ASML Netherlands B.V., 5504 DR Veldhoven (NL)
(72) Inventor: Tanasa, Gheorghe, 5621 BX Eindhoven (NL); Ten Kate, Nicolaas, 4286 EC Almkerk (NL); Vermeulen, Johannes, 5708 ZJ Helmond (NL); Philips, Danny, 5691 LG Son en Breugel (NL); Schepers, Maikel, 5671 AS Nuenen (NL); Van Bokhoven, Laurentius, 5625 SP Eindhoven (NL)
(74) Representative: Corcoran, Gregory Martin Mason

(57) **Abstract**

A fluid handling structure (100) is disclosed which is designed for all wet immersion lithography. The fluid handling structure has a first opening (110) to provide fluid to a space (11) between a final element of a projection system (PS) and a substrate (W) and/or substrate table, a barrier (130) to resist the flow of liquid out of the space between the fluid handling structure and the substrate, and a second opening (120), which opens into an area radially outwardly of the space, to provide a flow of fluid from the fluid handling structure onto a top surface of the substrate and/or substrate table radially outwardly of the space. A controller (140) may be provided such that flow of fluid towards a center of the substrate table is greater than the flow of fluid in a direction away from the center of the substrate table.

## Description

### Field

The present invention relates to a fluid handling structure, a lithographic apparatus and a method for manufacturing a device.

### Background

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. comprising part of, one, or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti-parallel to this direction. It is also possible to transfer the pattern from the patterning device to the substrate by imprinting the pattern onto the substrate.

It has been proposed to immerse the substrate in the lithographic projection apparatus in a liquid having a relatively high refractive index, e.g. water, so as to fill a space between the final element of the projection system and the substrate. In an embodiment the liquid is distilled water, although another liquid can be used. An embodiment of the present invention will be described with reference to liquid. However, another fluid may be suitable, particularly a wetting fluid, an incompressible fluid and/or a fluid with higher refractive index than air, desirably a higher refractive index than water. Fluids excluding gases are particularly desirable. The point of this is to enable imaging of smaller features since the exposure radiation will have a shorter wavelength in the liquid. (The effect of the liquid may also be regarded as increasing the effective numerical aperture (NA) of the system and also increasing the depth of focus.) Other immersion liquids have been proposed, including water with solid particles (e.g. quartz) suspended therein, or a liquid with a nano-particle suspension (e.g. particles with a maximum dimension of up to 10nm). The suspended particles may or may not have a similar or the same refractive index as the liquid in which they are suspended. Other liquids which may be suitable include a hydrocarbon, such as an aromatic, a fluorohydrocarbon, and/or an aqueous solution.

Submersing the substrate or substrate and substrate table in a bath of liquid (see, for example, United States Patent No. US 4,509,852) means that there is a large body of liquid that must be accelerated during a scanning exposure. This requires additional or more powerful motors and turbulence in the liquid may lead to undesirable and unpredictable effects.

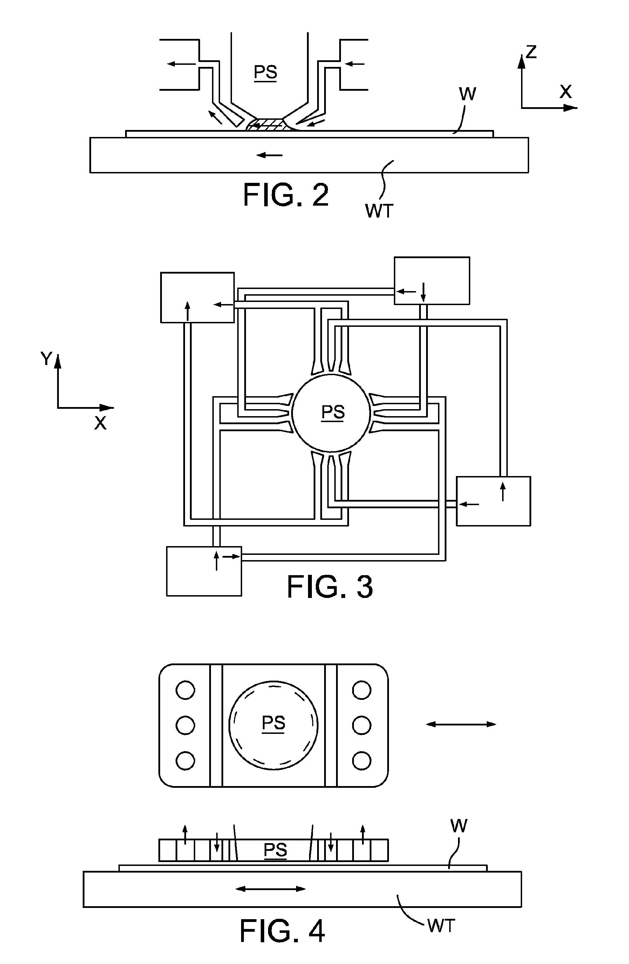

One of the arrangements proposed is for a liquid supply system to provide liquid on only a localized area of the substrate and in between the final element of the projection system and the substrate using a liquid confinement system (the substrate generally has a larger surface area than the final element of the projection system). One way which has been proposed to arrange for this is disclosed in PCT Patent Application Publication No. WO 99/49504. As illustrated in Figures 2 and 3, liquid is supplied by at least one inlet onto the substrate, preferably along the direction of movement of the substrate relative to the final element, and is removed by at least one outlet after having passed under the projection system. That is, as the substrate is scanned beneath the element in a -X direction, liquid is supplied at the +X side of the element and taken up at the -X side. Figure 2 shows the arrangement schematically in which liquid is supplied via inlet and is taken up on the other side of the element by outlet which is connected to a low pressure source. In the illustration of Figure 2 the liquid is supplied along the direction of movement of the substrate relative to the final element, though this does not need to be the case. Various orientations and numbers of in- and out-lets positioned around the final element are possible, one example is illustrated in Figure 3 in which four sets of an inlet with an outlet on either side are provided in a regular pattern around the final element.

A further immersion lithography solution with a localized liquid supply system is shown in Figure 4. Liquid is supplied by two groove inlets on either side of the projection system PS and is removed by a plurality of discrete outlets arranged radially outwardly of the inlets. The inlets and outlets can be arranged in a plate with a hole in its center and through which the projection beam is projected. Liquid is supplied by one groove inlet on one side of the projection system PS and removed by a plurality of discrete outlets on the other side of the projection system PS, causing a flow of a thin film of liquid between the projection system PS and the substrate W. The choice of which combination of inlet and outlets to use can depend on the direction of movement of the substrate W (the other combination of inlet and outlets being inactive).

In European patent application publication No. EP 1420300 and United States patent application publication no. US 2004-0136494, the idea of a twin or dual stage immersion lithography apparatus is disclosed. Such an apparatus is provided with two tables for supporting a substrate. Levelling measurements are carried out with a table at a first position, without immersion liquid, and exposure is carried out with a table at a second position, where immersion liquid is present. Alternatively, the apparatus has only one table.

PCT patent application publication WO 2005/064405 discloses an all wet arrangement in which the immersion liquid is unconfined. In such a system the whole top surface of the substrate is covered in liquid. This may be advantageous because then the whole top surface of the substrate is exposed to the substantially same conditions. This has an advantage for temperature control and processing of the substrate. In WO 2005/064405, a liquid supply system provides liquid to the gap between the final element of the projection system and the substrate. That liquid is allowed to leak over the remainder of the substrate. A barrier at the edge of a substrate table prevents the liquid from escaping so that it can be removed from the top surface of the substrate table in a controlled way. Although such a system improves temperature control and processing of the substrate, evaporation of the immersion liquid may still occur. One way of helping to alleviate that problem is described in United States patent application publication No. US 2006/0119809. A member is provided which covers the substrate W in all positions and which is arranged to have immersion liquid extending between it and the top surface of the substrate and/or substrate table which holds the substrate.

### Summary

A difficulty in immersion lithography, particularly in an all wet concept, is the risk of de-wetting of one or more parts of the substrate table. De-wetting is the spontaneous or induced generation and subsequent growth of dry patches in the fluid layer on the substrate and/or substrate table. De-wetting can result in loss of thermal control, a disturbed bulk flow of liquid off the substrate table which can result in splashing, extraction problems and/or the introduction of unwanted dynamic forces and defects (drying stains and bubbles).

It is desirable, for example, to provide a fluid handling structure in which measures are taken to address one or more of the above-mentioned difficulties or one or more other difficulties not discussed herein.

According to an aspect of the invention, there is provided a fluid handling structure configured to provide fluid to (i) a space between a projection system and a substrate and/or substrate table, and (ii) to a top surface of a substrate and/or substrate table radially outward of the space, the fluid handling structure comprising a first opening into the space to provide a flow of fluid from the fluid handling structure into the space, a barrier to resist flow of fluid out of the space between the fluid handling structure and the substrate, and a second opening, radially outward of the barrier relative to an optical axis of the projection system, to provide a flow of fluid from the fluid handling structure onto a top surface of the substrate and/or substrate table radially outward of the space.

According to an aspect of the invention, there is provided a fluid handling structure configured to provide fluid to a space between a projection system and a substrate and to a top surface of a substrate and/or substrate table radially outward of the space, the fluid handling structure comprising: an opening to provide fluid from the fluid handling structure onto the top surface; and a controller configured to control a flow of fluid out of the opening to be at a greater rate in a direction towards a center of the substrate table than in a direction away from the center of the substrate table.

According to an aspect of the invention, there is provided a device manufacturing method comprising projecting a beam of radiation onto a top surface of a substrate on a substrate table through immersion liquid which is provided to a space between a projection system and the substrate through a first opening of a fluid handling structure, wherein a barrier of the fluid handling structure resists flow of liquid out of the space between the fluid handling structure and the substrate and a second opening in the fluid handling structure provides fluid onto a top surface of the substrate and/or substrate table radially outward of the space.

According to an aspect of the invention, there is provided a device manufacturing method comprising projecting a beam of radiation onto a top surface of a substrate on a substrate table through immersion liquid which is provided to a space between a projection system and the substrate by a fluid handling structure, and providing a fluid onto a top surface of the substrate and/or substrate table radially outward of the space such that a flow of fluid in a direction towards a center of the substrate table is greater than in a direction away from the center.

According to an aspect of the invention, there is provided a fluid handling structure for an immersion lithographic apparatus, the fluid handling structure in use defining a space between a projection system and a substrate and/or the substrate table, the fluid handling structure comprising: a surface that defines an outer surface of the fluid handing structure; an opening defined in the outer surface, the opening configured to supply fluid to a top surface of a surface of a substrate table and/or a substrate, radially outward of the space; and a barrier positioned between the outer surface and the space, the barrier configured to resist the fluid from flowing into the space.

### Brief Description of the Drawings

Embodiments of the invention will now be described, by way of example only, with reference to the accompanying schematic drawings in which corresponding reference symbols indicate corresponding parts, and in which:

- Figure 1 depicts a lithographic apparatus according to an embodiment of the invention;

- Figures 2 and 3 depict a liquid supply system for use in a lithographic projection apparatus;

- Figure 4 depicts a further liquid supply system for use in a lithographic projection apparatus;

- Figure 5 depicts a further liquid supply system for use in a lithographic projection apparatus;

- Figure 6 depicts, in cross-section, a fluid handling structure according to an embodiment of the present invention;

- Figure 7 depicts, in cross-section, a detail of the fluid handling structure of Figure 6;

- Figures 8a-c illustrate, in cross-section, the effect of flow rate out of second openings on liquid behavior;

- Figures 9a and 9b illustrate, in plan, a fluid handling structure and substrate table;

- Figure 10 illustrates, in plan, an embodiment of the fluid handling structure;

- Figure 11 illustrates, in plan, a further embodiment of the fluid handling structure; and

- Figure 12 illustrates, in plan, a yet further embodiment of the fluid handling structure.

### Detailed Description

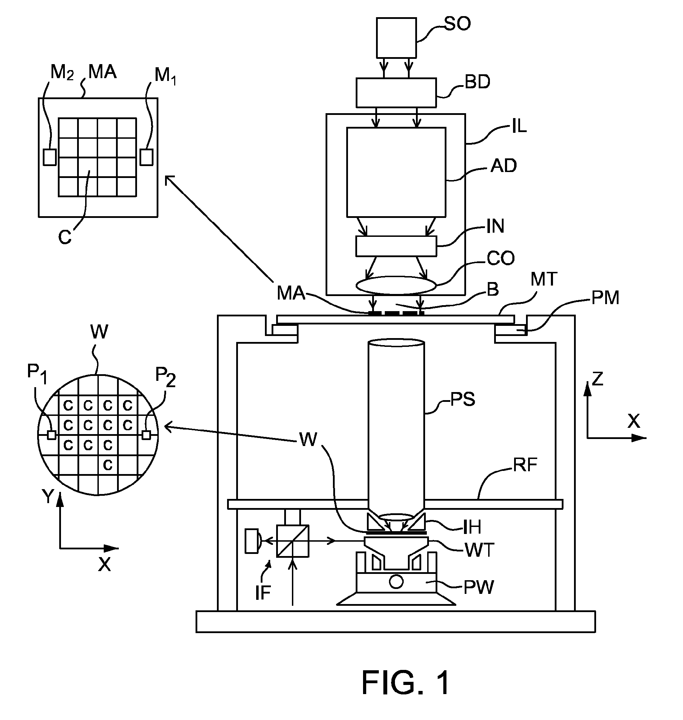

Figure 1 schematically depicts a lithographic apparatus according to one embodiment of the invention. The apparatus comprises:
- an illumination system (illuminator) IL configured to condition a radiation beam B (e.g. UV radiation or DUV radiation);
- a support structure (e.g. a mask table) MT constructed to support a patterning device (e.g. a mask) MA and connected to a first positioner PM configured to accurately position the patterning device in accordance with certain parameters;
- a substrate table (e.g. a wafer table) WT constructed to hold a substrate (e.g. a resist-coated wafer) W and connected to a second positioner PW configured to accurately position the substrate in accordance with certain parameters; and
- a projection system (e.g. a refractive projection lens system) PS configured to project a pattern imparted to the radiation beam B by patterning device MA onto a target portion C (e.g. comprising one or more dies) of the substrate W.

The illumination system may include various types of optical components, such as refractive, reflective, magnetic, electromagnetic, electrostatic or other types of optical components, or any combination thereof, for directing, shaping, or controlling radiation.

The support structure MT holds the patterning device. The support structure MT holds the patterning device in a manner that depends on the orientation of the patterning device, the design of the lithographic apparatus, and other conditions, such as for example whether or not the patterning device is held in a vacuum environment. The support structure MT can use mechanical, vacuum, electrostatic or other clamping techniques to hold the patterning device. The support structure MT may be a frame or a table, for example, which may be fixed or movable as required. The support structure MT may ensure that the patterning device is at a desired position, for example with respect to the projection system. Any use of the terms "reticle" or "mask" herein may be considered synonymous with the more general term "patterning device."

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

The patterning device may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam which is reflected by the mirror matrix.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

As here depicted, the apparatus is of a transmissive type (e.g. employing a transmissive mask). Alternatively, the apparatus may be of a reflective type (e.g. employing a programmable mirror array of a type as referred to above, or employing a reflective mask).

The lithographic apparatus may be of a type having two (dual stage) or more substrate tables (and/or two or more patterning device tables). In such "multiple stage" machines the additional tables may be used in parallel, or preparatory steps may be carried out on one or more tables while one or more other tables are being used for exposure.

Referring to Figure 1, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD comprising, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may comprise an adjuster AD configured to adjust the angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL may comprise various other components, such as an integrator IN and a condenser CO. The illuminator may be used to condition the radiation beam, to have a desired uniformity and intensity distribution in its cross-section.

The radiation beam B is incident on the patterning device (e.g., mask) MA which is held on the support structure (e.g., mask table) MT and is patterned by the patterning device. Having traversed the patterning device MA, the radiation beam B passes through the projection system PS, which focuses the beam onto a target portion C of the substrate W. With the aid of the second positioner PW and position sensor IF (e.g. an interferometric device, linear encoder or capacitive sensor), the substrate table WT can be moved accurately, e.g. so as to position different target portions C in the path of the radiation beam B. Similarly, the first positioner PM and another position sensor (which is not explicitly depicted in Figure 1) can be used to accurately position the patterning device MA with respect to the path of the radiation beam B, e.g. after mechanical retrieval from a mask library, or during a scan. In general, movement of the support structure MT may be realized with the aid of a long-stroke module (coarse positioning) and a short-stroke module (fine positioning), which form part of the first positioner PM. Similarly, movement of the substrate table WT may be realized using a long-stroke module and a short-stroke module, which form part of the second positioner PW. In the case of a stepper (as opposed to a scanner) the support structure MT may be connected to a short-stroke actuator only, or may be fixed. Patterning device MA and substrate W may be aligned using patterning device alignment marks M1, M2 and substrate alignment marks P1, P2. Although the substrate alignment marks as illustrated occupy dedicated target portions, they may be located in spaces between target portions (these are known as scribelane alignment marks). Similarly, in situations in which more than one die is provided on the patterning device MA, the patterning device alignment marks may be located between the dies.

The depicted apparatus could be used in at least one of the following modes:

1. In step mode, the support structure MT and the substrate table WT are kept essentially stationary, while an entire pattern imparted to the radiation beam is projected onto a target portion C at one time (i.e. a single static exposure). The substrate table WT is then shifted in the X and/or Y direction so that a different target portion C can be exposed. In step mode, the maximum size of the exposure field limits the size of the target portion C imaged in a single static exposure.

2. In scan mode, the support structure MT and the substrate table WT are scanned synchronously while a pattern imparted to the radiation beam is projected onto a target portion C (i.e. a single dynamic exposure). The velocity and direction of the substrate table WT relative to the support structure MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion.

3. In another mode, the support structure MT is kept essentially stationary holding a programmable patterning device, and the substrate table WT is moved or scanned while a pattern imparted to the radiation beam is projected onto a target portion C. In this mode, generally a pulsed radiation source is employed and the programmable patterning device is updated as required after each movement of the substrate table WT or in between successive radiation pulses during a scan. This mode of operation can be readily applied to maskless lithography that utilizes programmable patterning device, such as a programmable mirror array of a type as referred to above.

Combinations and/or variations on the above described modes of use or entirely different modes of use may also be employed.

Arrangements for providing liquid between a final element of the projection system PS and the substrate W can be classed into two general categories. These are the bath type arrangement in which the whole of the substrate W and optionally part of the substrate table WT is submersed in a bath of liquid and the so called localized immersion system which uses a liquid supply system in which liquid is only provided to a localized area of the substrate W. In the latter category, the space 11 filled by liquid is smaller in plan than the top surface of the substrate W and the area filled with liquid remains substantially stationary relative to the projection system PS while the substrate W moves underneath that area. A further arrangement, to which an embodiment of the present invention is directed, is the all wet arrangement in which the liquid is unconfined. In this arrangement substantially the whole top surface of the substrate W and all or part of the substrate table WT is covered in immersion liquid. The depth of the liquid covering at least the substrate W is small. The liquid may be a film, such as a thin film, of liquid on the substrate W. Any of the liquid supply devices of Figures 2-5 may be used in such a system; however, sealing features are not present, are not activated, are not as efficient as normal or are otherwise ineffective to seal liquid to only the localized area. Four different types of localized liquid supply systems are illustrated in Figures 2-5. The liquid supply systems disclosed in Figures 2-4 were described above.

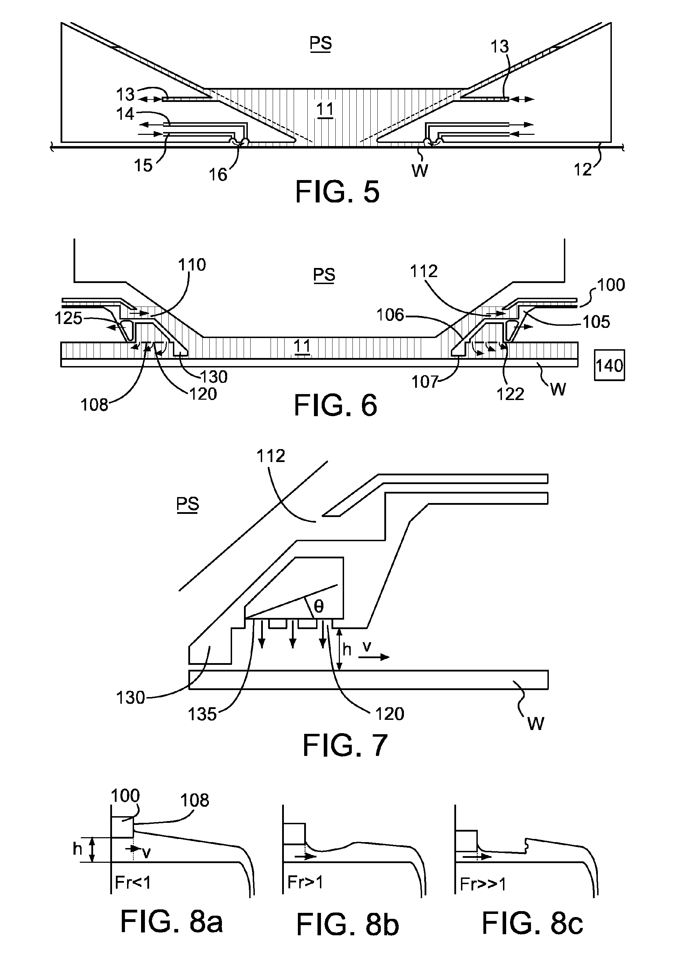

Another arrangement which has been proposed is to provide the liquid supply system with a liquid confinement member 12 which extends along at least a part of a boundary of the space 11 between the final element of the projection system PS and the substrate table WT. Such an arrangement is illustrated in Figure 5 which schematically depicts a localized liquid supply system or liquid handling structure with a barrier member or liquid confinement member 12, IH. The liquid confinement member 12 is substantially stationary relative to the projection system PS in the XY plane though there may be some relative movement in the Z direction (in the direction of the optical axis). In an embodiment, a seal is formed between the liquid confinement member 12, IH and the surface of the substrate W and may be a contactless seal such as a fluid seal, desirably a gas seal. (Please note that reference in the following text to surface of the substrate W also refers in addition or in the alternative to a surface of the substrate table WT, unless expressly stated otherwise.)

The liquid confinement member 12 at least partly contains liquid in the space 11 between a final element of the projection system PS and the substrate W. A contactless seal, such as a gas seal 16, to the substrate W may be formed around the image field of the projection system PS so that liquid is confined within the space 11 between the substrate W surface and the final element of the projection system PS. The space 11 is at least partly formed by the liquid confinement member 12 positioned below and surrounding the final element of the projection system PS. Liquid is brought into the space 11 below the projection system PS and within the liquid confinement member 12 by liquid inlet 13. The liquid may be removed by liquid outlet 13. The liquid confinement member 12 may extend a little above the final element of the projection system PS. The liquid level rises above the final element so that a buffer of liquid is provided. In an embodiment, the liquid confinement member 12 has an inner periphery that at the upper end closely conforms to the shape of the projection system PS or the final element thereof and may, e.g., be round. At the bottom, the inner periphery closely conforms to the shape of the image field, e.g., rectangular, though this need not be the case.

The liquid is contained in the space 11 by the gas seal 16 which, during use, is formed between the bottom of the liquid confinement member 12 and the surface of the substrate W. The gas seal 16 is formed by gas, e.g. air or synthetic air but, in an embodiment, N₂ or another inert gas. The gas in the gas seal 16 is provided under pressure via inlet 15 to the gap between liquid confinement member 12 and substrate W. The gas is extracted via outlet 14. The overpressure on the gas inlet 15, vacuum level on the outlet 14 and geometry of the gap are arranged so that there is a high-velocity gas flow inwardly that confines the liquid. The force of the gas on the liquid between the liquid confinement member 12 and the substrate W contains the liquid in a space 11. The inlets/outlets may be annular grooves which surround the space 11. The annular grooves may be continuous or discontinuous. The flow of gas is effective to contain the liquid in the space 11. Such a system is disclosed in United States patent application publication No. US 2004-0207824.

A fluid handling structure 100 according to an embodiment of the present invention is illustrated in cross-section in Figure 6. The fluid handling structure 100 is designed for an all wet (or unconstrained) arrangement. In the all wet arrangement the fluid handling structure 100 provides liquid to a space 11 between the final element of a projection system PS and the substrate W and/or substrate table WT, depending upon what is under the projection system PS. The fluid handling structure 100 also provides liquid to a top surface of the substrate W and/or substrate table WT which is not under the projection system PS. Put another way, the fluid handling structure 100 also provides liquid to a top surface of the substrate W and/or substrate table WT radially outward of the space 11. Therefore substantially the whole of the top surface of the substrate W and substrate table WT is covered in immersion liquid all the time during exposure.

Variations in height (or thickness of layer) of liquid on the top surface of the substrate W and/or substrate table WT not under the projection system PS can contribute to the growth of liquid finger instabilities. Such instabilities can lead liquid to splash and/or shoot off the edge of the substrate table WT and/or dry patches (i.e. de-wetting). The liquid handling structure 100 addresses one or more of these issues.

First, the fluid handling structure 100 is designed such that the flow of immersion liquid in the space 11 between the projection system PS and the substrate W and/or substrate table WT (the so called local supply) and the flow of liquid onto the top surfaces of the substrate W and/or substrate table WT not under the projection system PS (the so called bulk supply) are substantially separate or decoupled. This has an advantage that the two liquids do not mix. As a result, contamination picked up in the bulk flow is prevented from transfer to the space 11, contamination which may create defects. This de-coupling is partly achieved by providing at least one first opening 110 to provide liquid into the space 11 and at least one second opening 120 to provide liquid onto the top surface of the substrate W and/or substrate table WT not under the projection system PS. The fluid handling structure 100 is provided with a barrier 130 to resist the flow of liquid out of the space 11 between the fluid handling structure 100 and the substrate W (i.e. under the barrier 130). The first and second openings 110, 120 are on opposite sides of the barrier 130. That is, the second opening 120 is radially outward of the barrier 130 relative to an optical axis of the projection system.

Because the local flow and the bulk flow are substantially de-coupled, the first opening 110 provides liquid exclusively to the space 11. Similarly, the second opening 120 provides liquid substantially exclusively to the top surface of the substrate W and/or substrate table WT not under the projection system PS.

The de-coupling is partly achieved, for example, by controlling the flow of liquid through the first opening 110 and through the second opening 120. The flows are controlled such that a pressure of liquid in the space 11 is substantially equal to a pressure of liquid outside of the space 11 and in an area adjacent to the fluid handling structure 100 (i.e. on the top surface of the substrate W and/or substrate table WT not under the projection system PS). If there is no pressure gradient, there will be no driving force for mixing of the two liquids.

Second, the fluid handling structure 100 is controlled in such a way so as to reduce the chance of height or thickness differences in the bulk supply. This is achieved by controlling the flow of liquid out of the second opening 120 using a controller 140 as will be described below. If the Froude number of the horizontal flow of liquid in the bulk supply is kept between zero and two, desirably between zero and one, a step change in height in the bulk flow (i.e. a hydraulic jump) can be substantially avoided.

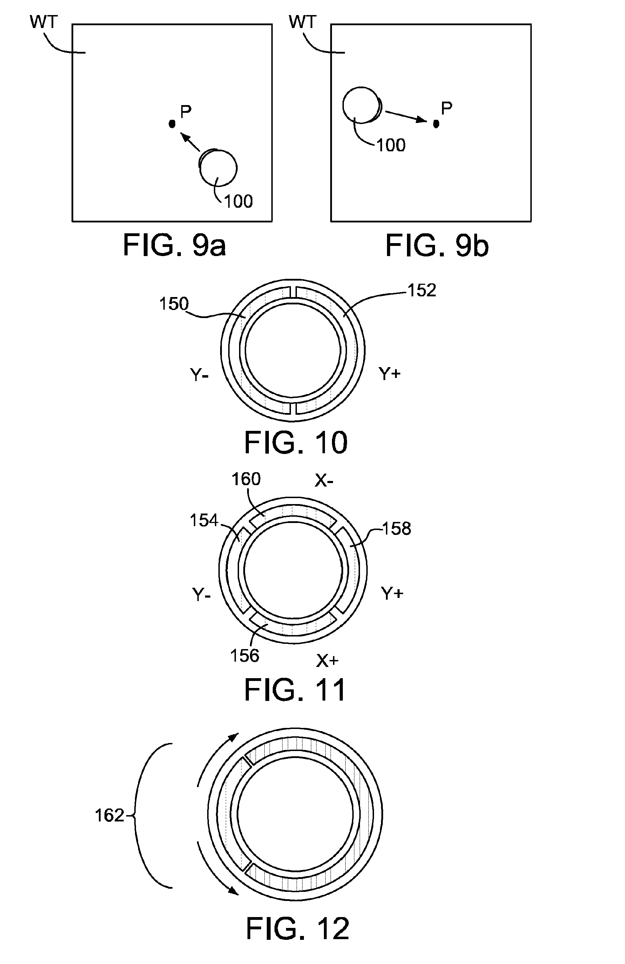

A third way in which the fluid handling structure 100 is adapted to avoid height differences is by helping to ensure that a flow of liquid in the bulk flow towards a center P (see Figures 9a and b) of the substrate table WT is greater than the flow in a direction away from the center P of the substrate table WT. This is described below in detail with reference to Figures 9a to 12.

Features of each of these three ways can be used individually or in combination. They will be described below in detail along with further refinements of the fluid handling structure 100.

The fluid handling structure 100 as illustrated in Figure 6 comprises a main body 105. The main body 105 presents an inner surface 106 which forms a surface of the space 11. That is, the space 11 is bounded at the top by the final element of the projection system PS, at the bottom by the substrate W (or substrate table WT or a shutter member) and at the sides by the surface 106 of the main body 105. Therefore, the main body 105 can be viewed as a barrier member or liquid confinement member 12, IH. The main body 105 also has the barrier 130 which is the part of the fluid handling structure 100 which is closest to the substrate W. The barrier 130 could be a barrier to (i.e. have a restriction to prevent) the flow of fluid (i.e. immersion liquid) from the inner, first opening 110 (into the immersion space 11 between the projection system PS, the substrate table WT and the main body 105 of the liquid confinement member 12), radially outwardly (relative to the optical axis which passes through the liquid confinement member 12). Desirably, the barrier 130 is configured substantially to prevent liquid supplied from the second opening 120 from flowing into the space 11. Desirably, the barrier 130 is configured to restrict/resist immersion fluid supplied to the space 11 from flowing radially outwardly out of the space 11 between the barrier 130 and the substrate W and/or substrate table WT. A gap 107 is present between the bottom of the barrier 130 and the substrate W. A high flow resistance is created by the barrier 130. This is by making the gap 107 height between 50-250 µm. This gap 107 is desirably 0.1-0.2 mm high. This compares with a distance of about 3 mm between the final element of the projection system PS and the substrate W. The gap 107 is kept small to restrict flow of liquid out of the space 11. That is, the main body 105 forms a barrier 130 which resists the flow of liquid out of the space 11 between the fluid handling structure 100 and the substrate W.

Liquid is provided to the space 11 via first opening 110. The first opening 110 is in an inner surface 106 of the fluid handling structure 100. The first opening 110 may comprise a plurality openings. The plurality of openings may be those disclosed, for example, in United States Patent Application No. 61/071,161, filed 16 April 2008.

A flow of liquid across the space 11 is desirable. Therefore, opposite the first opening 110 on the opposite side of the space 11 relative to the optical axis of the projection system PS in the fluid handling structure 100, there is positioned at least one further opening 112 to extract liquid out of the space 11. Control of the provision of liquid out of the first opening 110 into the space 11 and extraction of liquid out of the space 11 through the further opening 112 is by controller 140. The control provided by controller 140 is such that flow through the first opening 110 is of low velocity whereas extraction through the further opening 112 is based on a fixed volume flow. Example parameters are a flow rate out of first opening 110 of between 0.5 and 1.5 1pm (velocity of less than 0.3 m/second) and a fixed volume extraction out of further opening 112 of 2 to 4 1pm.

The second opening 120 is provided for the provision of liquid onto a top surface of the substrate W and/or substrate table WT not under the projection system PS. That is, the second opening 120 provides liquid to a top surface of the substrate W and/or substrate table WT radially outward of the space 11. The second opening 120 is provided in a surface of the fluid handling structure 100 which defines an outer surface 108 of the fluid handling structure 100. The flow of liquid out of the second opening 120 is controlled by the controller 140. The second opening 120 provides fluid to a location radially outward of the barrier 130 relative to the optical axis of the projection system PS. In contrast, the first opening 110 provides fluid to a location radially inward of the barrier 130 relative to the optical axis of the projection system PS. In an embodiment, the second opening 120 may be located radially outward of the barrier 130 and/or first opening 110 may be located radially inward of the barrier 130.

As can be seen, the second opening 120 is in an outer surface 108 of the fluid handling structure 100 which substantially faces the substrate W. That outer surface 108 is not a lower most surface of the fluid handling structure 100. That is, the outer surface 108 is further from the substrate W than the bottom surface of the barrier 130 which forms the gap 107. The barrier 130 is between the outer surface 108 of the fluid handling structure 100 and the space 11.

In an embodiment, the second opening 120 is desirably a distance away from the top surface of the substrate W of at least five times the distance between the barrier 130 and the substrate W and/or substrate table WT (i.e. five times the size of gap 107). Desirably the distance of the second opening 120 from the substrate W and/or substrate table WT is at least 7, 10 or 15 times the size of gap 107. Another way of viewing this is that there is a change in distance of the bottom of the fluid handling structure 100 to the substrate W and/or substrate table WT. In an embodiment, the second opening 120 is in a portion substantially parallel to the substrate W and/or substrate table WT which is further from the substrate W and/or substrate table WT than another portion parallel to the substrate W and/or substrate table WT.

The second opening 120 may comprise a plurality of second openings 120. The second opening 120 may have any shape. For example, there may be only a single slit which extends around the entire periphery (e.g. circumference) of the fluid handling structure 100. Alternatively or additionally, two or more second openings 120 could be positioned regularly or irregularly around the periphery of the fluid handling structure 100. The second opening 120 may be in the form of a circular hole, a square hole, a slot or any other shape. A plurality of openings 120 may be spaced in any one or two dimensional pattern around the periphery of the fluid handling structure 100.

The barrier 130 (or restriction) prevents the mixing of liquids of the bulk supply and the local supply in the immersion space 11. The liquid of the local supply (i.e., the liquid in the space 11) has stricter thermal conditioning and contamination control. In practice there is some mixing of the two liquids. Desirably the inward flow is substantially prevented by biasing the pressure differential between the bulk supply and the local supply so that if there is any flow, it is radially outwardly, from the space 11 to the bulk supply. Prevention of inward flow is desirable. Outward flow is simply restricted. Therefore, the barrier 130 is configured to restrict fluid out of the space 11, and desirably substantially to prevent fluid flowing into the space 11.

In an embodiment, the fluid may also be substantially prevented from flowing out of the space 11.

The bulk supply (which is a thermal conditioning liquid) is desirably separate from the local supply. Mixing allows the transfer of contamination, and would permit poorer thermal stability of the liquid in the space 11.

The liquid of the bulk supply supplied from the fluid handling system 100 should be controlled to help ensure the thickness of the thin film of liquid on the substrate W and substrate table WT is uniform. Movement of the substrate table WT relative to the fluid handling system 100 can cause disturbances in the thin film. The disturbances cause waves which may splash and cause de-wetting; the thermal conditioning of the substrate W would be disrupted. Variations in thickness of the film, even without de-wetting and splashing, could provide poorer thermal conditioning than a film of uniform thickness; evaporation from a part of the film with thinner depth will apply a greater heat loss locally, i.e. to the substrate W, than where the depth is thicker.

As is illustrated in Figure 6, at least one third opening 122 may be provided. The third opening 122 can be provided to extract liquid from the top surface of the substrate W and/or substrate table WT which is not under the projection system PS. Extracting liquid through the third opening 122 can help in controlling the velocity of the bulk flow. Extraction through the third opening 122 can be controlled by controller 140.

A gas opening 125 may be provided in the fluid handling structure 100. The gas opening 125 is in a surface of the fluid handling structure 100 which is above the surface in which the second opening 120 is formed. Gas which is humidified can be provided through the gas opening 125 onto an area on top of the liquid which is on the top surface of the substrate W and/or substrate table WT not under the projection system PS. The gas may have a relative humidity to the liquid of at least 40%, desirably at least 70%, desirably at least 90% and most desirably more than 95%, and desirably less than 99%, more desirably less than 97%. Providing the atmosphere above the liquid with humidified gas reduces evaporation (and therefore a cooling load) of the liquid. If the immersion liquid is degradable, for example, like some liquids used in a high NA apparatus, the gas provided through the gas opening 125 can be a non-oxidizing gas, for example, a purified inert gas may be used. Indeed, it may be desirable to use an inert gas which has been humidified with vapor of the immersion liquid. A plate may be provided above the liquid in order to contain the humidified gas.

Figure 7 shows a detail of the fluid handling structure 100. As can be seen, a surface 135 in which the second opening 120 is formed may be angled with respect to the top surface of the substrate W and/or substrate table WT. In an embodiment where the fluid handling structure 100 is circular, the surface in which the second opening 120 is formed would be in the form of a truncated cone. The angle θ of the surface 135 is desirably between 0 and 15°, desirably between 0 and 10° to the plane of the substrate W and/or substrate table WT. A radially inner most part of that surface 135 is closer to the substrate W than a radially outer most part of that surface 135. That is, the part of the surface 135 closest to the optical axis of the projection system PS is closer to the substrate W and/or substrate table WT than the part of the surface 135 further from the optical axis of the projection system PS.

Instead of angling the surface 135 in which the second opening 120 is formed, the second opening 120 itself may be angled (i.e. by forming a passage through the surface 135 which is substantially parallel to the top surface of the substrate W and/or substrate table WT at an angle). The opening 120 (or more precisely the angle of a passage behind the opening) can also be at the angle θ.

Varying the angle θ has an effect on the pressure which is produced at a certain flow rate in the bulk supply. Therefore, the choice of angle θ can be used to balance the pressure in between the liquid in the space 11 and the liquid outside of the space 11. As described above, by matching those pressures, mixing between the two liquid flows can be reduced or minimized.

Desirably the second opening 120 is designed to reduce or minimize hydrodynamic forces which are transmitted to the substrate W and/or substrate table WT by flow of liquid through the second opening 120. One way of doing this is to provide the second opening 120 with a width (e.g., diameter) which is less than the size of the gap 107 divided by 6, desirably less than the size of the gap 107 divided by 20. Also, it is desirable to provide the velocity of flow of liquid out of the second opening 120 to be less than three times the square root of the gravitational constant g multiplied by the size of the gap 107, desirably less than the square root of the gravitational constant multiplied by the size of the gap 107.

Figures 8a-c are cross-sections in the Z direction (i.e. the optical axis) illustrating schematically how the height of liquid radially outwardly of the outer surface 108 of the fluid handling structure 100 can vary as a function of flow velocity v radially outwardly under the fluid handling structure 100 parallel to the top surface of the substrate W. A Froude number (which is equal to the velocity of liquid v divided by the square root of the gravitational constant g times the distance between the top surface of the substrate W and/or substrate table WT and the second opening (h)) less than 1 (i.e. between zero and 1) is desirable. At that magnitude a stable height of liquid on the top surface of the substrate W and/or substrate table WT radially outwardly of the fluid handling structure 100 can be expected. This is illustrated in Figure 8a. If the velocity v of liquid is increased with the distance h of the second opening 120 from the substrate W remaining constant, a variation in the height of the liquid radially outwardly from the fluid handling structure 100 can be expected. The change in height of liquid starting at the outer surface 108 and moving radially outwardly is first a reduction in height before an increase in height before a further reduction in height. If the Froude number is kept below 2 (i.e. between zero and 2) a so called hydraulic jump can be avoided. See Figure 8b. If the velocity is such that the Froude number is well above 2, then a hydraulic jump is created. A hydraulic jump is illustrated in Figure 8c. This results from the velocity of liquid exiting the second opening being too high (or the distance h being too low). The presence of a hydraulic jump can lead to bubble entrapment and break up of the liquid layer (de-wetting). This can lead to dry spots which result in defects (drying stains, marks, sticking bubbles, etc.).

Another way of looking at this is that when a hydraulic jump is present, the speed of flow is higher than the surface gravity waves. That is, the horizontal speed of the liquid is lower than the speed of the waves.

The height h is desirably between 1 and 4 mm, desirably between 1.5 and 3 mm, desirably 2 mm.

It is possible to increase the horizontal speed of liquid v such that the hydraulic jump only occurs outside of the substrate table WT (i.e. does not occur on top of the substrate table WT), that is, the hydraulic jump illustrated in Figure 8c is moved radially away from the fluid handling structure 100 so that it no longer occurs. However, at this speed collection of fluid at the edge of the substrate table WT may become difficult.

Figures 9a and 9b illustrate schematically a plan view of the substrate table WT and show another principle of an embodiment of the invention. As is illustrated, irrespective of the position of the fluid handling structure 100 on the top surface of the substrate table WT, the bulk flow of liquid radially outwardly from the fluid handling structure 100 is always greater in a direction towards a center P of the substrate table WT than in other directions. There may be flow in the other directions or there may not be.

Flow through the third opening 122 into the fluid handling structure 100 can be used to adjust the pressure in the bulk liquid and/or to adjust the flow rate in the bulk liquid and/or to regulate the bulk liquid level and/or reduce wave amplitude and/or reduce wave forces on the fluid handling structure 100 for other reasons. Flow through the third opening 122 can be used to adjust the flow rate in a given direction. For example, only those third openings 122 (or only that portions of third opening 122) along a fraction of the periphery of the fluid handling structure 100 could have liquid extracted through them (or it) in order to reduce the flow rate of liquid out of that fraction of the periphery.

As is illustrated in Figure 9a, if the relative positions of the fluid handling structure 100 and substrate table WT are such that the fluid handling structure 100 is in the bottom right hand quarter of the substrate table WT (as viewed from above), the flow of fluid towards the center P of the substrate table WT (and therefore towards the top left hand corner of the substrate table WT as viewed from above) is increased over the flow in other directions. Similarly, if the fluid handling structure 100 is positioned in the center left of the substrate table WT as viewed from above (as illustrated in Figure 9b), the flow of liquid out of the fluid handling structure 100 in a direction towards the right as viewed from above will be greater than in other directions.

Figures 10-12 illustrate three further ways in which the flow rate of flow of liquid out of the substrate table WT can be varied according to peripheral position around the fluid handling structure 100. In Figure 10, the second opening 120 is split into two segments 150, 152. Each segment may comprise one second opening or a plurality of second openings 120. The second openings 120 associated with the first segment 150 can be controlled together. Similarly, the second openings 120 associated with the second segment 152 can be controlled together. Control is via controller 140.

Therefore, if the fluid handling structure 100 is in the left hand side of the substrate table WT, liquid flow through the second opening 120 of the second segment 152 will be greater than liquid flow of fluid through the second opening 120 in the first segment 150. Conversely, if the liquid handling structure 100 is in the right hand side of the substrate table WT, liquid flow out of the second opening 120 in the first segment 150 will be greater than liquid flow out of the second opening 120 in the second segment 152.

Figure 11 shows the case where the periphery of the fluid handling structure 100 is split into four different segments 154, 156, 158, 160. The segments are of equal size and the second opening 120 corresponding to each segment (and the third opening 122 corresponding to each segment) can be controlled independently of the second opening 120 of the other segments. In this instance, if the fluid handling structure 100 is in the top right hand corner of a substrate table WT, liquid flow out of segments 154 and 156 on the left and bottom of the fluid handling structure 100 would be greater than the flow of fluid out of the other two segments 158 and 160.

As will be appreciated, the periphery of the fluid handling structure 100 can be split into any number of segments and those segments may extend along any fraction of the periphery. The controller 140 can then control all of the second openings 120 and further openings 122 according to in which segment they are located.

A further embodiment is illustrated in Figure 12. In this embodiment the fluid handling structure 100 or part of the fluid handling structure 100 which contains the second opening 120 is rotatable. In this way the second opening 120 only needs to be provided along a portion 162 of the periphery of the fluid handling structure 100 (or the density of openings 120 can be increased along a portion 162 of the periphery). The fluid handling structure 100 or the part of the fluid handling structure 100 can then be rotated such that the greater flow of liquid out of the second opening 120 can be its maximum in the direction towards the center P of the substrate table WT.

In an embodiment, a fluid handling structure to provide fluid to (i) a space between a final element of a projection system and a substrate and/or substrate table, and (ii) to a top surface of a substrate and/or substrate table not under the projection system is provided. The fluid handling structure comprises a first opening into the space to provide a flow of fluid from the fluid handling structure into the space, a barrier to resist flow of fluid out of the space between the fluid handling structure and the substrate, and a second opening radially outward of the barrier relative to an optical axis of the projection system to provide a flow of fluid from the fluid handling structure onto a top surface of the substrate and/or substrate table radially outwardly of the space. In an embodiment, the fluid handling structure further comprises a controller configured to control the flow of fluid out of the first opening and/or the second opening. Desirably the controller is configured to control the flow of fluid out of the second opening such that fluid flowing radially outwardly of the fluid handling structure has a Froude number of between 0 and 2, desirably of between 0 and 1. Desirably the controller can vary the flow rate of fluid out of the second opening dependent upon a position of the fluid handling structure relative to a substrate table. Desirably the controller can control flow out of the second opening such that a flow in a direction towards a center of a substrate table is greater than a flow in a direction away from the center of the substrate table. Desirably the controller can control the flow of fluid outside of the fluid handling structure via the second openings and/or via a third opening which is open to an area surrounding the space. Desirably the controller can vary the removal rate of fluid from around a portion of a periphery of the fluid handling structure. Desirably the controller can control the flow of fluid through the first opening and through the second opening such that a pressure of fluid in the space is substantially equal to a pressure of fluid outside the space and in an area adjacent the fluid handling structure. Desirably the controller can control the pressures by varying of flow rate, and/or flow direction, and/or flow angle. Desirably the second opening is in a surface which is parallel to a top surface of a substrate or inclined at an angle selected from 0-10° relative to a plane of the substrate and/or substrate table, the surface being closer to the substrate near to an optical axis of the projection system and further from the optical axis away from the projection system. Desirably the fluid handling structure is constructed and arranged such that fluid which has exited the first opening is substantially de-coupled from fluid which has exited the second fluid opening. In an embodiment the fluid handling structure further comprises a gas opening, the gas opening being open to liquid on the top surface of the substrate and/or substrate table not under the projection system. Desirably the gas opening is connected to a humidified gas source to provide humidified gas above the top surface.

In an embodiment, an immersion lithography apparatus has, in use, substantially a whole of a top surface of a substrate table and a substrate covered in fluid and comprises a fluid handling structure according to the above paragraph. Desirably a distance between the barrier and a top surface of a substrate and/or substrate table is between 50 and 250 µm. Desirably a distance between the second opening and the substrate and/or substrate table is at least five times the distance between the barrier and the substrate and/or substrate table. Desirably a width of the second opening is at least greater than a distance between the opening and the substrate and/or substrate table divided by six, desirably greater than the distance divided by 20. Desirably a flow velocity of fluid out of the second opening is less than 3 times the square root of g times the distance of the opening to the substrate and/or substrate table, wherein g is the gravitational constant. Desirably a flow rate of fluid out of the second opening is in the range of 0.2-6.0 1pm.

In a further embodiment, a fluid handling structure to provide fluid to a top surface of a substrate and/or substrate table not under a projection system is disclosed. The fluid handling structure comprises an opening to provide fluid from the fluid handling structure onto the top surface and a controller to control flow of fluid out of the opening to be at a greater rate in a direction towards a center of the substrate table than in a direction away from the center of the substrate table. Desirably the opening comprises a plurality of openings around a periphery of the fluid handling structure, wherein the controller controls the flow of fluid out of one or more of the openings according to the opening's position around the periphery of the fluid handling structure and according to the position of the fluid handling structure relative to the substrate table. Desirably the periphery of the fluid handling structure is split into a plurality of segments, at least one of the segments having opening, flow out of the opening of each segment being controlled by the controller according to the position of the fluid handling structure relative to the substrate table. Desirably the opening is provided at different densities around a periphery of the fluid handling structure, and the opening is rotatable around an optical axis of the projection system.

In a further embodiment, an immersion lithography apparatus that has, in use, substantially a whole of a top surface of the substrate table and a substrate covered in fluid, comprises the fluid handling structure of the above paragraph.

In an embodiment, a device manufacturing method comprises projecting a beam of radiation onto the top surface of a substrate on a substrate table through immersion liquid which is provided to a space between a final element of a projection system and the substrate through a first opening of a fluid handling structure, wherein a barrier of the fluid handling structure resists the flow of liquid out of the space between the fluid handling structure and the substrate and a second opening in the fluid handling structure provides fluid onto a top surface of the substrate and/or substrate table not under the projection system.

In an embodiment, a device manufacturing method comprises projecting a beam of radiation onto a top surface of a substrate on a substrate table through immersion liquid which is provided to a space between a final element of a projection system and the substrate by a fluid handling structure, and providing a fluid onto a top surface of the substrate and/or substrate table not under a projection system such that a flow of fluid in a direction towards a center of the substrate table is greater than in a direction away from the center.

In an embodiment, the fluid handling structure comprises a fluid handling structure for an immersion lithographic apparatus, the fluid handling structure in use defining a space between a projection system and a substrate and/or the substrate table, the fluid handling structure comprising a surface that defines an outer surface of the fluid handing structure, a barrier positioned between the outer surface and the space, an opening defined in the outer surface, the opening configured to supply immersion fluid to a top surface of a surface of a substrate table and/or a substrate, radially outward of the space, wherein the barrier is configured to resist immersion fluid from flowing into the space. Desirably the fluid handling structure further comprises an inner opening defined in an inner surface of the fluid handling structure, the inner opening configured to supply immersion fluid into the space, the fluid handling structure confining to the space the immersion fluid supplied to the space. Desirably the barrier is configured to restrict/resist immersion fluid supplied to the space from flowing radially outwardly out of the space between the barrier and the substrate and/or substrate table.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, flat-panel displays, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist), a metrology tool and/or an inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

The terms "radiation" and "beam" used herein encompass all types of electromagnetic radiation, including ultraviolet (UV) radiation (e.g. having a wavelength of or about 365, 248, 193, 157 or 126 nm). The term "lens", where the context allows, may refer to any one or combination of various types of optical components, including refractive and reflective optical components.

While specific embodiments of the invention have been described above, it will be appreciated that the invention may be practiced otherwise than as described. For example, the invention may take the form of one or more computer programs containing one or more sequences of machine-readable instructions describing a method as disclosed above, or one or more data storage medium (e.g. semiconductor memory, magnetic or optical disk) having such one or more computer program stored therein. The one or more different controllers referred to herein may be operable when the one or more computer programs are read by one or more computer processors located within at least one component of the lithographic apparatus. One or more processors are configured to communicate with the at least one of the controllers; thereby the controller(s) operate according the machine readable instructions of one or more computer programs.

One or more embodiments of the invention may be applied to any immersion lithography apparatus, in particular, but not exclusively, those types mentioned above and whether the immersion liquid is provided in the form of a bath, only on a localized surface area of the substrate, or is unconfined. In an unconfined arrangement, the immersion liquid may flow over the surface of the substrate and/or substrate table so that substantially the entire uncovered surface of the substrate table and/or substrate is wetted. In such an unconfined immersion system, the liquid supply system may not confine the immersion fluid or it may provide a proportion of immersion liquid confinement, but not substantially complete confinement of the immersion liquid.

A liquid supply system as contemplated herein should be broadly construed. In certain embodiments, it may be a mechanism or combination of structures that provides a liquid to a space between the projection system and the substrate and/or substrate table. It may comprise a combination of one or more structures, one or more liquid inlets, one or more gas inlets, one or more gas outlets, and/or one or more liquid outlets that provide liquid to the space. In an embodiment, a surface of the space may be a portion of the substrate and/or substrate table, or a surface of the space may completely cover a surface of the substrate and/or substrate table, or the space may envelop the substrate and/or substrate table. The liquid supply system may optionally further include one or more elements to control the position, quantity, quality, shape, flow rate or any other features of the liquid.

The descriptions above are intended to be illustrative, not limiting. Thus, it will be apparent to one skilled in the art that modifications may be made to the invention as described without departing from the scope of the claims set out below.

## Claims

1. A fluid handling structure configured to provide fluid to (i) a space between a projection system and a substrate and/or substrate table, and (ii) to a top surface of a substrate and/or substrate table radially outward of the space, the fluid handling structure comprising:
a first opening into the space to provide a flow of fluid from the fluid handling structure into the space;
a barrier to resist flow of fluid out of the space between the fluid handling structure and the substrate; and
a second opening, radially outward of the barrier relative to an optical axis of the projection system, to provide a flow of fluid from the fluid handling structure onto a top surface of the substrate and/or substrate table radially outward of the space.

2. The fluid handling structure of claim 1, further comprising a controller configured to control flow of fluid out of the first opening and/or the second opening.

3. The fluid handling structure of claim 2, wherein the controller is configured to control flow of fluid out of the second opening such that fluid flowing radially outwardly of the fluid handling structure has a Froude number of between 0 and 2, desirably of between 0 and 1.

4. The fluid handling structure of claim 2 or claim 3, wherein the controller is configured to vary a flow rate of fluid out of the second opening dependent upon a position of the fluid handling structure relative to a substrate table.

5. The fluid handling structure of claim 4, wherein the controller is configured to control flow out of the second opening such that a flow in a direction towards a center of a substrate table is greater than a flow in a direction away from the center of the substrate table.

6. The fluid handling structure of any one of claims 2-5, wherein the controller is configured to control flow of fluid outside of the fluid handling structure via the second opening and/or via a third opening which is open to an area surrounding the space.

7. The fluid handling structure of claim 6, wherein the controller is configured to vary the removal rate of fluid from around a portion of a periphery of the fluid handling structure.

8. The fluid handling structure of any one of claims 2-7, wherein the controller is configured to control flow of fluid through the first opening and through the second opening such that a pressure of fluid in the space is substantially equal to a pressure of fluid outside the space and in an area adjacent the fluid handling structure.

9. The fluid handling structure of claim 8, wherein the controller is configured to control the pressures by varying of flow rate, and/or flow direction, and/or flow angle.

10. The fluid handling structure of any one of the preceding claims, wherein the second opening is in a surface which is parallel to a top surface of a substrate and/or substrate table or inclined at an angle selected from 0-10° relative to a plane of the substrate and/or substrate table, the surface being closer to the substrate and/or substrate table near to an optical axis of the projection system and further from the optical axis away from the projection system.

11. The fluid handling structure of any one of the preceding claims, wherein the fluid handling structure is configured such that fluid which has exited the first opening is substantially de-coupled from fluid which has exited the second fluid opening.

12. The fluid handling structure of any one of the preceding claims, further comprising a gas opening, the gas opening being open to liquid on the top surface of the substrate and/or substrate table radially outward of the space.

13. The fluid handling structure of claim 12, wherein the gas opening is connected to a humidified gas source and configured to provide humidified gas above the top surface.

14. An immersion lithography apparatus in which, in use, substantially a whole of a top surface of a substrate table and a substrate is covered in fluid, the apparatus comprising a fluid handling structure of any one of the preceding claims.

15. A device manufacturing method comprising projecting a beam of radiation onto a top surface of a substrate on a substrate table through immersion liquid which is provided to a space between a projection system and the substrate through a first opening of a fluid handling structure, wherein a barrier of the fluid handling structure resists flow of liquid out of the space between the fluid handling structure and the substrate and a second opening in the fluid handling structure provides fluid onto a top surface of the substrate and/or substrate table radially outward of the space.
